# EUROPEAN PATENT SPECIFICATION

(11) **EP 2 270 519 B1**
(45) Date of publication and mention of the grant of the patent: **27.11.2013**
(21) Application number: 10167750.8
(22) Date of filing: 29.06.2010
(51) Int. Cl.: G01R 1/04, G01D 11/24, H05K 5/00

(54) **Multimeter**
Multimeter
Multimètre

(30) Priority: 29.06.2009 CN 200920160592 U
(43) Date of publication of application: 05.01.2011
(73) Proprietor: Danaher (Shanghai) Industrial Instrumentation Technologies R&D Co Ltd, Changning Area Shanghai (CN)
(72) Inventor: Lagerberg, Christopher W, Seattle WA 98115 (US); Wang, Hui, Changning Area Shanghai (CN); Cheek, Steve, Changning Area Shanghai (CN)
(74) Representative: Stainthorpe, Vanessa Juliet

(56) References cited:
- US-A- 2 732 491
- US-A1- 2002 135 349
- US-B1- 6 271 654
- US-B1- 6 669 362
- SUPREME INSTRUMENTS CORP.: "Electronic Voltmeter - MODEL 549"[Online] 12 November 2007 (2007-11-12), page 1, XP002602191 Retrieved from the Internet: URL:http://www.stevenjohnson.com/supreme/p ics/supreme549.jpg> [retrieved on 2010-09-24] -& DIGITAL-DETECTIVE.CO.UK: "WebDate - screenshot establishing the date of the lastest modification of the webpage of XP002602191"[Online] 24 September 2010 (2010-09-24), XP002605017 WEBDATE Retrieved from the Internet: URL:www.digital-ditective.co.uk> [retrieved on 2010-09-24]

## Description

### TECHNICAL FIELD

The present disclosure relates generally to an electronic measuring device that is commonly used for measuring current, voltage, resistance, capacitance, frequency and other electrical parameters. A multimeter may also measure parameters reflecting the conditions of the environment such as temperature. Thus, a multimeter according to embodiments of the present disclosure combines multiple measurement functions in a single device. Certain embodiments of multimeters according to the present disclosure may include a display that can be reoriented and a plurality of redundant controls corresponding to individual orientations of the display. Certain other embodiments of multimeters according to the present disclosure may include a magnetic clamp for mounting the multimeter on a ferrous structure.

### BACKGROUND

A conventional multimeter has a control panel, a display screen, and a signal input device on its front face. A rotary switch is the main component of the control panel and allows the user to select the measurement functions that the user wants to conduct. The display screen shows the measurement results. Further, the input device has input jacks for the testing leads.

One disadvantage of conventional multimeters is that the rotary switch is prone to operational errors. For example, a user may mistakenly select the function for measuring current while measuring voltage. As a result, the multimeter may be damaged and also the user could receive an electrical shock.

Another problem with the conventional multimeters is that the test leads have permanently attached extension wires. Such extension wires are useful for measuring electrical circuits that are difficult to reach. However, long and dangling extension wires may get in the user's way and interfere with the user's work. Furthermore, when the multimeter has a pair of test leads with extension wires, the user needs to hold the test leads with both hands, one in each hand. As a result, the user has difficulty holding the multimeter and needs to find a place to put the multimeter or have another person hold the multimeter. Sometimes it is difficult to find a place to put the multimeter and there is no one else to ask for help.

U.S. Patent No. 6,271,654 to L. Chen, entitled, "Multifunctional Meter with Dual Input Channels" is directed toward a multifunctional meter that has two pairs of input channels and a function key for selecting and setting different functions. However, as shown in FIG. 1 of this patent, the display is not spatially separated by the input channel controls.

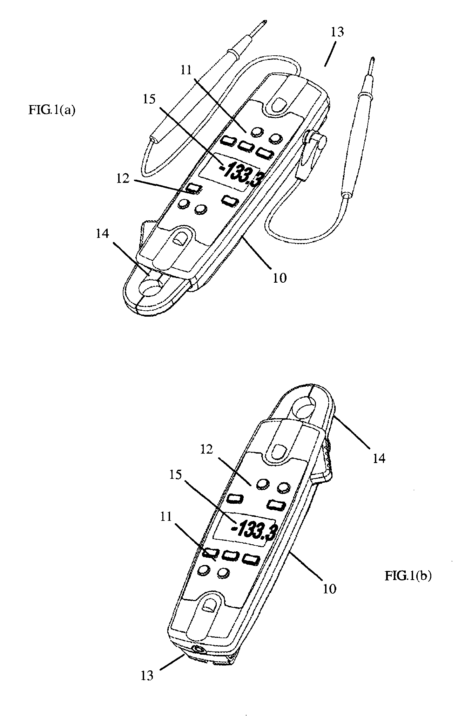

U.S. Patent No. 2,732,491 to V.A. Jeannot, entitled, "Testing Instrument Assembly" is directed toward a testing instrument assembly that performs the testing operations required for testing and repair of radio and television apparatuses. However, this patent only has a single control that is configured to select a measurement function of the testing instrument, item 45 in Figure 1.

The electronic voltmeter, model 549, manufactured by Supreme Instruments Corp, and shown at website: http://stevenjohnson,com/supreme/pics/supreme549.jpg is a testing instrument that tests resistance, current, and AC and DC voltages. However, this instrument only has a single control that is configured to select a measurement function of the testing instrument, namely, the circuit selector shown to the left of the meter display.

### SUMMARY

The invention is defined in the claim 1 and the preferred embodiments are defined in the appended claims.

In an embodiment, a multimeter is provided with a plurality of control panels on its face for controlling a plurality of measurement functions. There may be two or more separate control panels on the face of the device. The two or more control panels are located spatially separately from one another. In certain embodiments, the control panels are separated from one another by one or more display screens. The one or more display screens can change, e.g., flip, display orientation in accordance with the position of the multimeter or the selected measurement function so that the display can be conveniently read by the user. Each control panel has a corresponding input device that is used for performing one or more measurement functions that may be selected from the control panel. A control panel may be located near its corresponding input device, or may be located away from its corresponding input device. The spatial separation of the control panels from one another is user friendly and will reduce the likelihood of user errors in the selection of the right measurement functions. Each control panel may allow selection of one or more measurement functions. Measurement functions based on the same measurement mechanism may be controlled by the same control panel.

In another embodiment, a multimeter has at least one input jack that allows a test lead to directly plug in, and at least one test lead has a detachable extension wire. In some embodiments, a multimeter has a pair of test leads and one or both test leads are detachably attached to extension wires, and the multimeter also has an input jack for a detached test lead to connect to. The detachable test lead can be removed from its extension wire and can be directly attached to the body of the multimeter through the input jack. When conducting a measurement using a multimeter with a test lead directly connected to an input jack and a test lead connected to an extension wire, the user can hold the multimeter in one hand and the test lead with extension wire in the other hand. Therefore, the user does not need to worry about the placement of the multimeter.

In another embodiment, a multimeter comprises a built-in test lead which may be substituted for a test lead with an extension wire. Thus, it also provides a solution for the placement of the multimeter.

In another embodiment, a multimeter comprises a first control panel, a second control panel, and a display screen disposed on a first face of the multimeter. The first control panel and the second control panel allow selection of one or more measurement functions, and the first control panel and the second control panel are spatially separated by the display screen. The multimeter further comprises a first input device and a second input device for performing one or more measurement functions selected from the first control panel and the second control panel. The first control panel and the first input device located at a first end of the multimeter, and the second control panel and the second input device are located at a second end, which is opposite to the first end, of the multimeter. The measurement functions selected from the first control panel are conducted using the second input device located at the second end of the multimeter, and the measurement functions selected from the second control panel are conducted using the first input device located at the first end of the multimeter. Alternatively, the measurement functions selected from the first control panel are conducted using the first input device located at the first end of the multimeter, and the measurement functions selected from the second control panel are conducted using the second input device located at the second end of the multimeter. At least one of the first input device and the second input device may be a pair of test leads with extension wires, and one or both test leads of the pair is detachable from its extension wire. The multimeter may further comprise an input jack to which a test lead can be directly connected without an extension wire or the multimeter may further comprise a built-in test lead. At least one of the first input device and the second input device may be a non-contact type measurement sensor. The first control panel may allow the selection of current measurement and the second control panel may allow the selection of voltage measurement. The current measurement may be conducted using a U-shaped current sensor or a close jaw current sensor. The voltage measurement may be conducted through a pair of test leads with one or more test leads having detachable extension wires. The display screen may automatically change its display orientation, e.g., flip, in accordance with the measurement function selected so that the display can be conveniently read by the user. The long axis of the display screen may be substantially parallel to the long axis of the body of the multimeter. The long axis of the display screen may be substantially perpendicular to the long axis of the body of the multimeter. The first and second control panels may use membrane touch buttons as function buttons. The multimeter may further comprise one or more control panels.

The multimeter may further comprise a magnetic portion attached to the body of the multimeter for mounting the multimeter to a metal support. The magnetic portion may comprise a switch to turn ON and OFF the magnetic force. The magnetic portion may comprise a magnet, a rotating means for rotating the magnet, and a pair of non-magnetic metal parts.

In another embodiment, the portable electrical measuring device may be a multimeter, or a process meter, or a LED testing device. The portable electrical measuring device may further comprise a first control panel and a second control panel. The first control panel and the second control panel may be located on opposite sides of the display along the lengthwise direction of the portable electrical measuring device. The portable electrical measuring device may further comprise a first input device and a second input device. The first input device may be located at one end of the portable electrical measuring device near the second control panel, and the second input device may be located at the other end of the portable electrical measuring device near the first control panel. The measurement functions selected from the first control panel may be conducted using the first input device located at the first end of the multimeter, and the measurement functions selected from the second control panel may be conducted using the second input device located at the second end of the multimeter. Because the display can change display orientation according to user's selection, it is very convenient for using.

In another embodiment, a multimeter is provided with a magnetic portion for magnetically mounting the body portion of the device to a metal surface. The magnetic portion may comprise a switch to turn ON and OFF the magnetic force, thus reducing any interference that the magnetic portion may have on any measurement by the multimeter and to better control the attachment of the multimeter to a metal surface.

In another embodiment, a multimeter having a magnetic portion comprises at least one magnet part and at least one magnetic conductive part. The at least one magnet part and the at least one magnetic conductive part may be relatively movable to switch the magnetic portion ON and OFF. When the magnetic portion is turned ON, the magnetic force of the magnetic portion is strong enough to attach the multimeter to a metal support. When the magnetic portion is turned OFF, the magnetic force of the magnetic portion is too weak to attach the multimeter to a metal support. A metal support may be any object on which the magnetic portion can be attached. At least part of a metal support may be made of magnetic conductive materials, for example, a metal support may be an iron frame, or an iron door of a cabinet, etc. A multimeter is a portable electrical measuring device having at least one of voltage measurement function, electric current measurement function, and electric resistance measurement function. The magnetic portion may comprise a first magnet part, a second magnet part, a first magnetic conductive part, and a second magnetic conductive part. When the magnetic portion is turned ON, the north pole of the first magnet part only connects with the first magnetic conductive part, and the south pole of the second magnet part only connects with the second magnetic conductive part. When the magnetic portion is turned OFF, the north pole and the south pole of the first magnet part are connected through the first and/or the second magnetic conductive parts. The first magnet part and the second magnet part may be located side by side and at the same side of the first magnetic conductive part and the second magnetic conductive part which are located side by side. A first end of the first magnet part facing the magnetic conductive parts is the north pole, and a second end opposite to the first end of the first magnet part is the south pole. A first end of the second magnet part facing the magnetic conductive parts is the south pole, and a second end opposite to the first end of the second magnet part is the north pole. The first magnet part and the second magnet part may be positioned relatively fixed to each other and separated to form a magnet part assembly. The first magnetic conductive part and the second magnetic conductive part may be positioned relatively fixed to each other and separated to form a magnetic conductive part assembly. The magnet part assembly and the magnetic conductive part assembly may move substantially parallel to a plane formed by the magnet part assembly or the magnetic conductive assembly and relatively to each other. The magnet part assembly and the magnetic conductive part assembly may rotate relative to each other. The magnetic conductive part assembly may be fixed, and the magnet part assembly may be rotatable relative to the magnetic conductive part assembly. The position of the magnet part assembly when the magnetic portion is switched ON may be turned about 90 degrees relative to the position of the magnet part assembly when the magnetic portion is switched OFF. The first magnet part, the second magnet part, the first magnetic conductive part, and the second magnetic conductive part may be flat shaped, may have substantially the same cross section, or may be flat semi-circle shaped, flat arch shaped, flat rectangular shaped, and flat triangle shaped etc. The first magnet part, the second magnet part, the first magnetic conductive part, and the second magnetic conductive part are flat arch shaped, and the magnet part assembly and the magnetic conductive part assembly may be flat disk shaped. The magnet parts may contain a permanent magnet. The magnetic conductive parts may be made of any magnetic conductive materials including, for example, iron, iron alloys, nickel, silicon steel, beryllium monium alloys, and iron oxide materials, etc. A spacing strip may be placed between the first magnet part and the second magnet part, and a spacing strip may be placed between the first magnetic conductive part and the second magnetic conductive part, to separate them. The spacing strips may be made of any non-magnetic conductive materials including, for example, copper, aluminum, lead, tin, gold, silver, engineering plastics, etc. The magnetic portion may further comprise a magnetic conductive cover. The first magnet part and the second magnet part may be sandwiched between the magnetic conductive cover and the first magnetic conductive part and the second magnetic conductive part to reduce friction caused by relative movement between the first magnet part assembly and the first magnetic conductive part assembly, and to reduce magnetic leakage. The magnetic conductive cover may be made of magnetic conductive material. The magnetic portion may be set on the back of the multimeter. The magnetic portion may be set on a retaining clip mounted on the back of the multimeter and the at least one magnetic conductive part may be fixed in the retaining clip. The magnetic portion may be fixed permanently on the multimeter or may be detachable from the multimeter. For example, the magnetic portion may be mounted on the multimeter using a buckle structure. The first and the second magnet parts and the at least one magnetic conductive part may move relative to each other to switch the magnetic portion ON and OFF. When the magnetic portion is turned ON, the north pole of the first magnet part and the south pole of the second magnet part are disconnected. When the magnetic portion is turned OFF, the north pole of the first magnet part and the south pole of the second magnet part are connected by the at least one magnetic conductive part. The magnetic portion may comprise a magnet part and at least one magnetic conductive part. When the magnetic portion is turned ON, magnetic lines from the north pole of the magnet part must go through a metal support to reach the south pole of the magnet part. When the magnetic portion is turned OFF, magnetic lines from the north pole of the magnet part only go through the at least one magnetic conductive part to reach the south pole of the magnet part. Therefore the magnetic portion has no force or forces too weak to attach the multimeter to a metal support. When the magnetic portion is turned ON, most magnetic lines from the north pole of the first magnet part can go through the first magnetic conductive part, a metal support, and the second magnetic conductive part to reach the south pole of the second magnet part. When the magnetic portion is turned OFF, most magnetic lines from the north pole of the first magnet part only go through the first and the second magnetic conductive parts to reach the south pole of the second magnet part. Consequently the magnetic portion has no force or forces too weak to attach the multimeter to the metal support. The magnet part may move relative to the first magnetic conductive part and the second magnetic conductive part. When the magnetic portion is turned ON, the north pole and the south pole of the magnet part are magnetically connected with the first magnetic conductive part and the second magnetic conductive part, respectively. When the magnetic portion is turned OFF, the north pole and the south pole of the magnet part are both magnetically connected to at least one of the first and the second magnetic conductive parts.

The multimeter may have any combination of the foregoing features. The above and other objects, features and advantages of the present invention will become apparent from the following detailed description with reference to the accompanying drawings, which are a part of this disclosure and which illustrate, by way of example, the principles of this invention.

### BRIEF DESCRIPTION OF THE DRAWINGS

Figure 1(a) and Figure 1(b) are perspective views of an embodiment of a multimeter according to the present application. The multimeter has a close jaw non-contact type sensor at one end, and a test lead with an extension wire (Figure 1(a)) or an input jack for a test lead to directly plug in (Figure 1(b)) at the other end. The multimeter has two control panels and a display screen located between the two control panels, wherein the long axis of the display screen is substantially perpendicular to the long axis of the multimeter. Figure 1(a) shows the multimeter with control panel 11 on the top and control panel 12 on the bottom, display screen 15 shows the number with its top pointing to the control panel 11; and Figure 1(b) shows the flip side view of Figure 1(a), in which, the display screen shows the number with its top pointing to control panel 12.

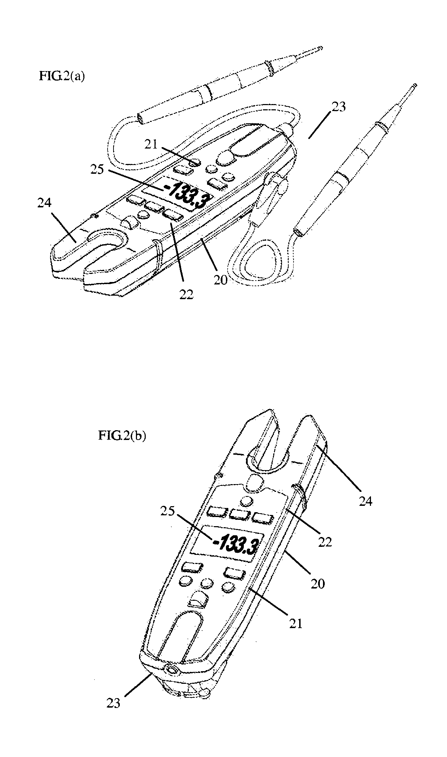

Figure 2(a) and Figure 2(b) are perspective views of another embodiment of a multimeter according to the present application. The multimeter has an open non-contact type sensor at one end, and a test lead with an extension wire (Figure 2(a)) or an input jack for a test lead to directly plug in (Figure 2(b)) at the other end. The multimeter has two control panels and a display screen located between the two control panels, wherein the long axis of the display screen is substantially perpendicular to the long axis of the multimeter. Figure 2(a) shows the multimeter with control panel 21 on the top and control panel 22 on the bottom; and Figure 2(b) shows the flip side view of Figure 2(a).

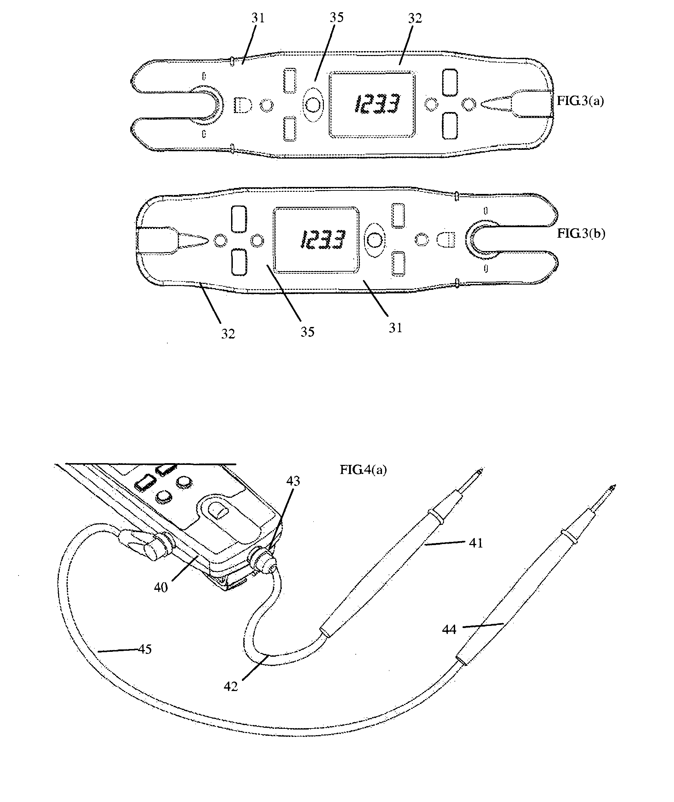

Figure 3(a) and Figure 3(b) are perspective views of yet another embodiment of a multimeter according to the present application wherein the multimeter has an open non-contact type sensor at one end and an input ack for a test lead to directly plug in at the other end. The multimeter has two control panels and a display screen located between the two control panels, wherein the long axis of the display screen is substantially parallel to the long axis of the multimeter. Figure 3(a) shows the multimeter with control panel 31 on the left and control panel 32 on the right; and Figure 3(b) shows the flip side view of Figure 3(a).

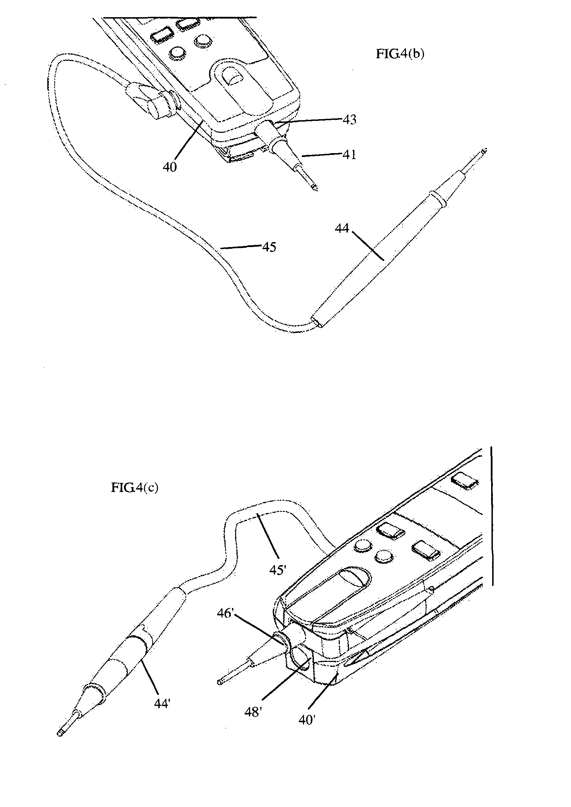

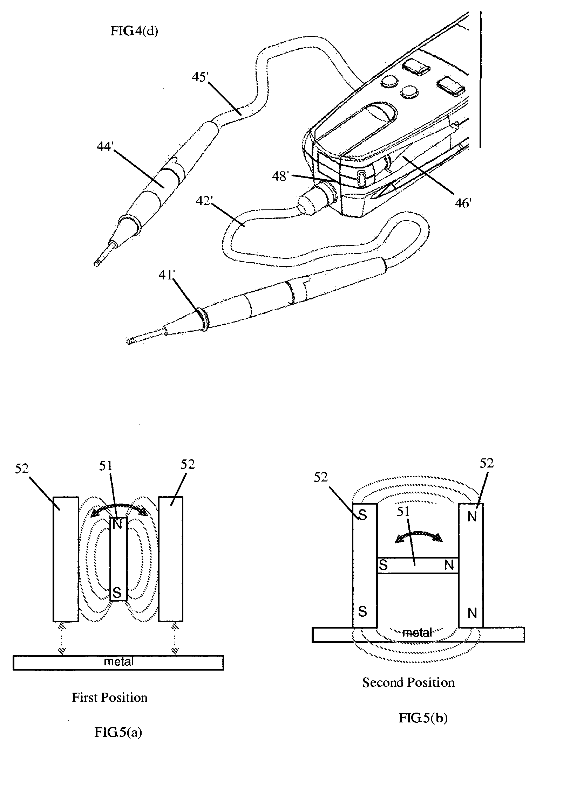

Figure 4(a)-(d) are perspective views of a further embodiment of a multimeter according to the present application. Figure 4(a) shows the multimeter including a pair of test leads with extension wires. Figure 4(b) shows a multimeter having a test lead with an extension wire and another test lead detachably attached to the multimeter. Figure 4(c) shows a multimeter having a test lead with an extension wire and a built-in test lead. Figure 4(d) shows a multimeter having a test lead with an extension wire, and another test lead with an extension wire that is plugged in an input jack that can open and close.
Figure 5(a) and Figure 5(b) illustrate an embodiment of a magnetic portion according to the present application. In Figure 5(a), the magnetic portion is in the OFF position; and in Figure 5(b), the magnetic portion is in the ON position.
Figure 6(a)-(c) are perspective views of a multimeter with a magnetic portion attached to its back. In Figure 6(a), the magnetic portion is in the ON position; Figure 6(b) is a side view of a multimeter with a magnetic portion attached; and in Figure 6(c), the magnetic portion is in the OFF position.
Figure 7 illustrates another embodiment of a magnetic portion according to the present application.
Figure 8a illustrates the magnetic portion of Figure 7 when it is turned ON.
Figure 8b illustrates the magnetic portion of Figure 7 when it is turned OFF.
Figure 9 illustrates yet another embodiment of a magnetic portion according to the present application.
Figure 10a illustrates the magnetic portion of Figure 9 when it is turned ON.
Figure 10b illustrates the magnetic portion of Figure 9 when it is turned OFF.
Figure 11 a illustrates a further embodiment of a magnetic portion according to the present application when it is turned ON.
Figure 11b illustrates the magnetic portion of Figure 11a when it is turned OFF.

### DETAILED DESCRIPTION OF ILLUSTRATED EMBODIMENTS

In an embodiment illustrated in Figure 1(a) and Figure 1(b), a multimeter comprises two separate control panels on its front face. As shown in Figure 1(a), multimeter 10 has control panels 11 and 12 located at the two ends of the front face. Input devices 13 and 14 are located at the two ends of the multimeter 10 and near control panels 11 and 12, respectively. The input devices are used to obtain measurement data of interest from an electrical circuit. Each control panel has its corresponding input device which can be used to obtain measurement data from an electrical circuit according to one or more measurement functions selected from the control panels. Between control panels 11 and 12 is display screen 15 which shows the measurement data.

In Figure 1(a), the multimeter 10 has an elongated shape and control panels 11 and 12 are located at the opposite ends of the multimeter 10. Control panel 11 is located at one end of the multimeter 10 near input device 13 which is used for conducting one or more measurement functions selected from control panel 11. Control panel 12 is located at the other end of the multimeter 10 near input device 14 which is used for conducting one or more measurement functions selected from control panel 12. The control panels may have traditional push buttons as the selection buttons. They may also use the membrane touch buttons as the selection buttons. Furthermore, the control panels may use touch screen for making selections by gently touching the surface of the control panel, e.g., by hand.

The display screen 15 can show the measurement results obtained from any selected measurement function. In Figure 1(a) and Figure 1(b), display screen 15 is rectangular and has its long axis substantially perpendicular to the long axis of the multimeter. The display by the display screen can change display orientation, e.g., flip, automatically in accordance with the position of the multimeter or the selected measurement function so that the display can be conveniently read by the user. As shown in Figure 1 (a), when a user measures with control panel 11 and input device 13 and with the end having control panel 11 and input device 13 pointing away from the user, the data shown on the display screen appears in an orientation in which control panel 11 and input device 13 is on its top. On the other hand, if the user turns the multimeter upside down with the end having control panel 12 and input device 14 pointing away from the user, and measures with the control panel 12 and input device 14, then the data on the display screen also flips upside down, i.e., the data appears in an orientation in which control panel 12 and input device 14 is on its top, see Figure 1(b). In another embodiment, the display orientation of the display screen can be changed by the user according to the specific situations. For example, a button or a control means can be provided on the multimeter to change the display orientation.

In Figure 1(a) and Figure 1(b), a control panel and its corresponding input device are located at the same side of the display screen on the multimeter. A control panel may also be located away from its corresponding input device. For example, in Figure 2(a) and Figure 2(b), a control panel and its corresponding input device are located at the opposite ends of the multimeter. As shown in Figure 2(a) and Figure 2(b), multimeter 20 has control panels 21 and 22 located at the two ends of the front side of the multimeter 20. Input devices 23 and 24 are also located at the two ends of the multimeter 20, respectively. Input device 24 is used for performing the one or more measurement functions that may be selected from the control panel 21. Meanwhile, input device 23 is used for performing the one or more measurement functions that may be selected from the control panel 22. A display screen 25 is located between control panels 21 and 22. In this embodiment, each of the control panels and the corresponding input devices are located on the opposite ends of the multimeter 20 and separated by the display screen 25. In Figure 2(a) , when a user measures with control panel 22 and input device 23, the end having input device 23 points away from the user and the data shown on the display screen will appear in an orientation in which input device 23 is on its top. In Figure 2(b), when the user measures with control panel 21 and input device 24, the end having input device 24 points away from the user and the data on the display screen will appear in an orientation in which input device 24 is on its top.

In another embodiment shown in Figure 3(a) and Figure 3(b), the display screen may have its long axis substantially parallel to the long axis of the multimeter. In Figure 3(a), the multimeter is held with the control panel 31 on the left and control panel 32 on the right, and the display by the display screen shows the data with the control panel 31 on its left and control panel 32 on its right. Thus, the data is conveniently read by the user. In Figure 3(b), the multimeter is turned by 180 degrees with control panel 32 on the left and control panel 31 on the right, and the display by the display screen also flips orientation by 180 degrees and shows the data with control panel 32 on the left and control panel 31 on the right.

Although the display screens shown in the above embodiments are rectangular, they may be square, oval, circular or any other shape of interest and/or convenience. The display screen may be a liquid crystal display or use any other display technique including, e.g., VFD. Sensors may be used to determine the placing orientation of the multimeter and thus change the display orientation accordingly.

The multimeters described in the present application may measure any electrical parameters that can be measured by a conventional multimeter. Such electrical parameters include, without limitation, current, voltage, resistance, capacitance, frequency, and power, etc. The multimeters described in the present application may also measure some non-electrical parameters such as the temperature, humidity, etc. The multimeters described in the present application can have a plurality of control panels, each of which is controls one or more measurement functions for measuring various parameters. For example, in the multimeter shown in Figure 1(a), control panel 11 can be used for controlling voltage measurement; control panel 12 can be used for controlling current measurement. Each control panel can be used for controlling one or more measurement functions. For example, in the multimeter of Figure 1(a), control panel 11 can be used for selection of voltage and resistance measurements; control panel 12 can be used for selection of current measurements in amperes or milli-amperes. The multimeter may also measure non-electrical parameters such as the temperature, humidity, etc.

The input devices may measure a parameter with or without physically contacting an electrical circuit. In certain embodiments, the input device 13 of the multimeter in Figure 1(a) is a pair of test leads with extension wires for measuring voltage and resistance of an electrical circuit by physically contacting the electrical circuit and input device 14 is a close jaw sensor for measuring the current of an electrical circuit without physically contacting it. In certain embodiments, one or more input devices may be contact type sensors, including, e.g., test leads with or without extension wires. In the case of test leads with extension wires, the test leads may or may not be detachable from the extension wires. In some embodiments, one or more input devices may be non-contact type sensors. The non-contact type sensors may be U-shaped open sensors or close jaw sensors. Combinations of contact type sensors and/or non-contact type sensors may be provided on the same multimeter.

The multimeter may comprise more than two control panels. The control panels may be located on different sides of the multimeter. For example, a multimeter may comprise some control panels on its front face and some control panels on its back face. Each control panel may control the measurement function of its corresponding input device.

Other aspects according to the present disclosure may include a multimeter that has one or more test leads with detachable extension wires. In some embodiments, a multimeter has a pair of test leads and one or both test leads are detachable from the extension wires. Furthermore, the multimeter may have an input ack to allow a test lead detached from the extension wire to directly plug in and perform measurement functions. In certain embodiments, a multimeter has a first and second test leads with extension wires, and a third test lead that is directly attached to the body of the multimeter. A measurement function can be conducted using the first and second test leads or the first and third test leads, etc. The second and third test leads, however, may not conduct measurement functions at the same time.

In Figure 4(a), the multimeter 40 comprises a pair of test leads 41 and 44 that are detachably attached to extension wires 42 and 45. In the embodiment shown in Figure 4(a), measurements can be performed using test leads 41 and 44 while both are attached to their respective extension wires. The user may use both hands to hold the test leads for measurement but not hold the multimeter at the same time. In Figure 4(b), the test lead 41 is detached from extension wire 42 and plugged into the input jack 43 and test lead 44 is attached to extension wire 45. As shown in Figure 4(b), measurements can be performed using test lead 41 and test lead 44. In this embodiment, the user may use one hand to hold the multimeter 40 with test lead 41 plugged into the input jack 43 and the other hand may hold test lead 44. The embodiment in Figure 4(b) may be used when it is not necessary to use extension wires for both test leads, for example, when the object to be measured is accessible by a test lead attached directly to the multimeter. By this way, the user does not need to worry about where to put the multimeter when conducting a measurement.

In Figure 4(c), the multimeter 40' comprises a test lead 44' and its extension wire 45' and a built-in test lead 46' that is directly attached to the multimeter. Furthermore, test lead 41' and its extension wire 42' (not shown in Figure 4(c)) are connected to the multimeter at a contact point. In Figure 4(c), the measurement may be conducted with test leads 44' and 46' as the input devices and an input jack 48' is covered. Furthermore, in Figure 4(d), when test lead 46' is in the not-for-use position, input jack 48' will be open. Test lead 41' and its extension wire 42' can be removed from its contact point and directly plugged into input jack 48' to perform a measurement. Therefore, a measurement can be conducted with test leads 44' and 46' as well as test leads 44' and 41'. For safety concerns, test leads 41' and 46' may be prevented from being electrically connected to the multimeter at the same time. When test lead 46' is in the use position, input jack 48' is covered so that test lead 41' and its extension wire 42' cannot be plugged into it. When test lead 46' is folded back to the not-for-use position, input jack 48' is opened and may be connected to test lead 41' and its extension wire 42'. Test leads 41' and 44' may also be permanently or detachably attached to extension wires 42' and 45'. Test lead 46' can fold back through rotation or other means such as sliding.

In another embodiment, a multimeter includes a magnetic portion for magnetically mounting the body portion of the device to a metal surface. The magnetic portion may be placed on any part of the device body that is convenient for it to attach the device body to a metal surface. In some embodiments, the magnetic portion has a switch to turn ON and OFF the magnetic force. When the switch is turned ON, the magnetic portion will have magnetic force and be able to attach the device to a metal surface. When the switch is turned OFF, the magnetic portion will not have sufficient magnetic force to attach the device body to a metal surface. When the magnetic force is turned OFF, it will minimize any interference that the magnetic force may have on the measurement functions of the multimeter. Also, if the environment has lots of metal objects and the magnetic force of the magnetic portion is ON all the time, the magnetic portion may attach to metal objects that the user does not want it to. If the magnetic force can be turned OFF with a switch and un-intentional attachment can be avoided.

In certain embodiments, a magnetic portion has an inside structure as shown in Figure 5. The magnetic portion has a magnet 51 and two pole cores 52, wherein magnet 51 is located between the two pole cores 52. Magnet 51 may rotate between positions 1 and 2 in the space between the two pole cores. In Figure 5(a), when magnet 51 is in position 1, the north pole and south pole of its magnetic field is parallel to the pole cores, and the magnetic rays between the north pole and the south pole run within the space between the pole cores but do not activate the pole cores. Accordingly, the pole cores do not have sufficient magnetic force and cannot attach to a metal object. The magnetic portion is turned OFF when magnet 51 is in position 1. In Figure 5(b), when magnet 51 is in position 2, the north pole and south pole of its magnetic field is perpendicular to the pole cores, and the magnet activates the pole cores to form the north pole and south pole, respectively. Thus the two pole cores transmit magnetic force and can attach to a metal object. The magnetic portion is turned ON when magnet 51 is in position 2. Magnet 51 is switched between position 1 and position 2 by, e.g., a rotating means not shown in Figure 5 (a) and Figure 5(b). The rotating mean may be any structure that can achieve the rotating function. In another embodiment, the pole cores may be rotatable relative to magnet 51. In another embodiment, the pole cores and magnet are rotatable relative to one another. The magnetic portion may comprise a magnet, a rotating device to rotate the magnet, and a set of non-magnetic metal elements.

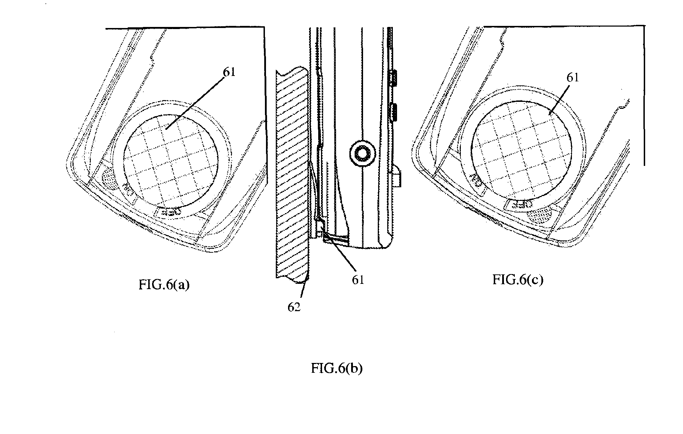

Figure 6(a) shows a magnetic portion 61 attached to the back of a multimeter. The magnetic portion 61 is set at the ON position, indicating that the magnetic force is turned on. Figure 6(b) shows the side view of a multimeter having a magnetic portion 61 attached to its back and mounting to a metal plate 62. Figure 6(c) shows a magnetic portion 61 attached to the back of a multimeter, wherein the magnetic portion 61 is set at the OFF position, indicating that the magnetic force is turned off.

In certain embodiments, the multimeter has a plurality of control panels, one or more display screens that can change display orientation, one or more test leads that are detachable from their extension wires, one or more input jacks in which test leads can be plugged directly, one or more built-in test leads, and/or one or more magnetic portions.

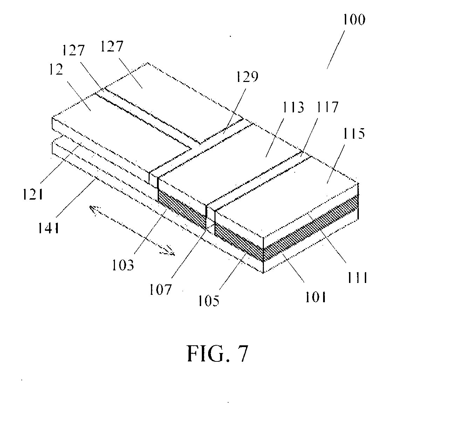

Figure 7 illustrates an embodiment of a magnetic portion 100 according to the present application. Magnetic portion 100 comprises magnet part assembly 101 and magnetic conductive part assemblies 111 and 121. Magnet part assembly 101 comprises flat rectangular shaped magnet parts 103 and 105, and spacing strip 107 positioned between magnet part 103 and 105. Spacing strip 107 is made of non-magnetic conductive material. Magnet parts 103 and 105 with spacing strip 107 there between forms a single flat rectangular shaped structure. The magnet part assembly 101 has a flat rectangular shape. The magnetic conductive part assembly 111 comprises magnetic conductive parts 113 and 115 and a spacing strip 117 between the magnetic conductive parts 113 and 115. Magnetic conductive parts 113 and 115 and spacing strip 117 form a single flat rectangular shaped structure. The magnetic conductive part assembly 121 comprises magnetic conductive parts 123 and 125 and a spacing strip 127 between the magnetic conductive parts 123 and 125. The magnetic conductive parts 123 and 125 and spacing strip 127 there between forms a single flat rectangular shaped structure. The magnetic conductive part assemblies 111 and 121 are separated by spacing strip 129. Spacing strip 129 is substantially perpendicular to spacing strip 127. The magnetic conductive part assemblies 111 and 121 and spacing strip 129 forms a single flat rectangular shaped structure. A magnetic conductive cover 141 is located underneath magnet part assembly 101, thus magnet part assembly 101 is sandwiched between magnetic conductive cover 141 and magnetic conductive part assemblies 111 and 121. In one embodiment, magnet part assembly 101 is located closely to and may even contact, and is substantially parallel to magnetic conductive cover 141 and magnetic conductive part assemblies 111 and 121. In one embodiment, magnet part assembly 101 can slide parallel to and along the direction of magnetic conductive part assemblies 111 and 121. The magnetic conductive cover 141 is made of magnetic conductive material, thus the friction caused by the movement between magnet part assembly 101 and magnetic conductive part assemblies 111 and 121 may be reduced, and magnetic leakage from magnetic portion 100 can be minimized.

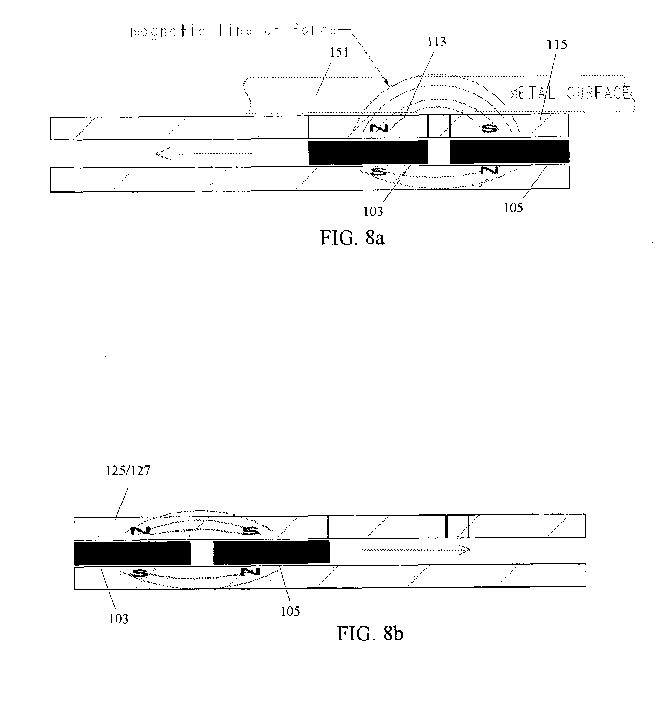

In an embodiment illustrated in Figure 8a, the top side of magnet part 103 is the north pole and the bottom side is the south pole; the top side of magnet part 105 is the south pole and the bottom side is the north pole. When the magnet part assembly 101 is in the first position, the north pole of magnet part 103 faces magnetic conductive part 113 and the south pole of magnet part 105 faces magnetic conductive part 115. As a result, most magnetic lines from the north pole of magnet part 103 go through, in order, magnetic conductive part 113, metal support 151 located above magnetic conductive part assembly 111 (e.g., an iron rack), and magnetic conductive part 115 to reach the south pole of magnet part 105. Therefore the external magnetic force of magnetic portion 100 at this state, i.e., the magnetic force for attaching to another object, is strong enough to attach a multimeter to metal support 151.

In an embodiment illustrated in Figure 8b, magnet part assembly 101 is moved to the second position, magnet part 103 and magnet part 105 each face part of both magnetic conductive parts 113 and 115. Most magnetic lines from the north pole of magnet part 103 go through magnetic conductive parts 113 and 115 to reach the south pole of magnet part 105 and do not go through metal support 151. Therefore magnetic portion 100 has no external magnetic force or has weak magnetic forces that are not sufficient to attach a multimeter to metal support 151. In one embodiment, magnetic portion 100 is switched ON and OFF when magnet part assembly 101 is slid between the first position and the second position.

In one embodiment, spacing strips may be made of any non-magnetic conductive materials. In another embodiment, spacing strips may also be replaced by a void. In other words, magnet parts 103 and 105 may be separated by space. In one embodiment, spacing strip 127 can be removed to integrate magnetic conductive parts 123 and 125 as a single piece.

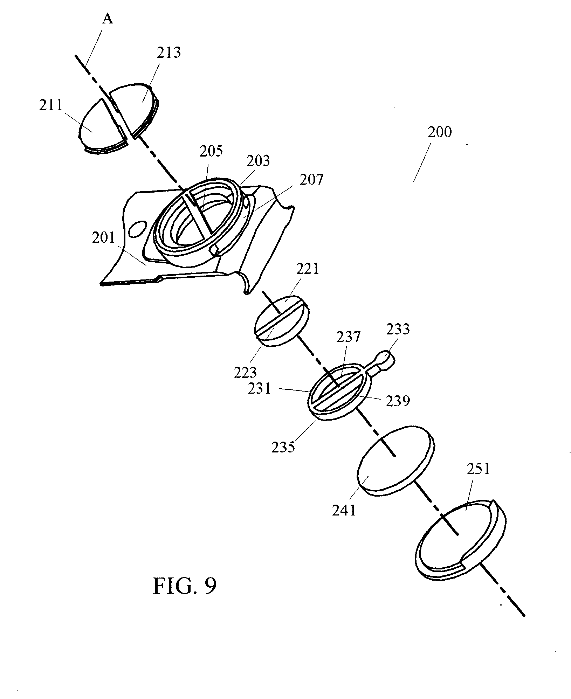

Figure 9 illustrates a magnetic portion 200 according to an embodiment. Magnetic portion 200 is placed on retaining clip 201 on the back of a multimeter (not shown) to increase the distance between magnetic portion 200 and the circuits inside the multimeter, thus any interference of magnetic portion 200 with the measurement of the multimeter is reduced. The multimeter may be hung on a user's clothing using retaining clip 201. Magnetic portion 200 comprises housing 203, magnetic conductive parts 211 and 213, magnet parts 221 and 223, switch 231, magnetic conductive cover 241, and bottom cover 251. In one embodiment, magnetic conductive parts 211 and 213 are integrated with housing 203 by molding, and spacing strip 205 is formed in the molding process between magnetic conductive parts 211 and 213. Magnetic conductive parts 211 and 213 are flat arch shaped and substantially on the same plane. Magnetic conductive parts 211 and 213 and spacing strip 205 form an integrated flat circular shaped part. Switch 213 comprises lever 233 and ring 235 integrated as a whole. Ring 235 is divided by lever 233 into two substantially symmetric arch shaped openings 237 and 239. Magnet parts 221 and 223 are located within openings 237 and 239, respectively. Switch 231 is received in housing 203 with lever 233 extending out of opening 207 of housing 203 for a user to operate. Magnetic conductive cover 241 is located underneath switch 231 in housing 203. Thus magnet parts 221 and 231 in openings 237 and 239 of switch 231 are sandwiched between magnetic conductive cover 241 and magnetic conductive parts 211 and 213. Bottom cover 251 is attached to the bottom of housing 203 by, for example, a buckle structure or molding or microwave heating, to keep magnet parts 221 and 223, switch 231, and magnetic conductive cover 241 in housing 203. Housing 203, spacing strip 205, switch 231, and bottom cover 251 are made of non-magnetic conductive materials. Magnetic conductive parts 211 and 213 and magnetic conductive cover 241 are made of magnetic conductive materials. Moving lever 233 allows magnet parts 221 and 223 to turn around axis A relative to magnetic conductive parts 211 and 213, thus switching magnetic portion 200 ON and OFF. In one embodiment, when lever 233 is moved to the left side, magnetic portion 200 is turned ON. On the other hand, when lever 233 is moved to the right side, magnetic portion 200 is turned OFF. The angle between lever 233 at the left side position and lever 233 at the right side position is about 90 degrees.

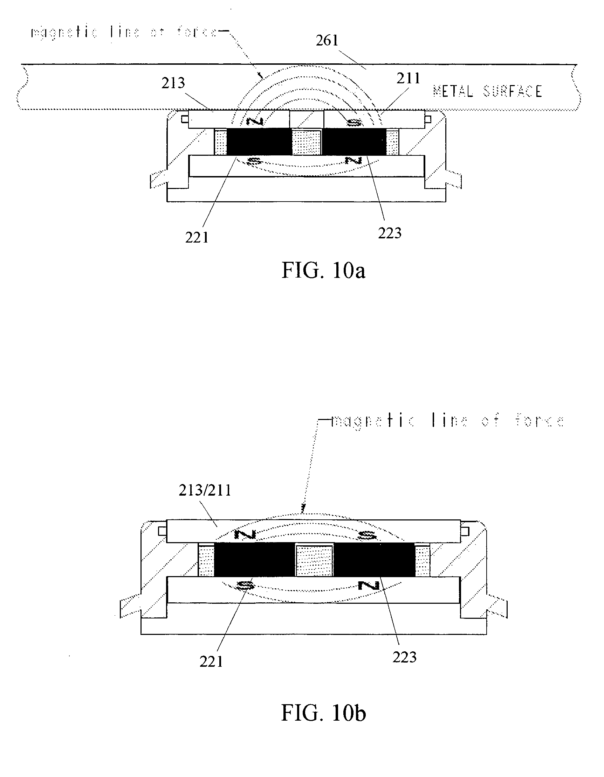

Figure 10a illustrates a perspective view of magnetic portion 200 when it is turned ON. In one embodiment, the top side of magnet part 221 is a north pole and the bottom side is a south pole; the top side of magnet part 223 is a south pole and bottom side is a north pole. Magnet part 221 faces magnetic conductive part 213 and magnet part 223 faces magnetic conductive part 211. As a result, most magnetic lines from the north pole of magnet part 221 go through, in order, magnetic conductive part 213, metal support 261, and magnetic conductive part 211 to reach the south pole of magnet part 223. Therefore, the external magnetic force of magnetic portion 200 is strong enough to attach the multimeter to metal support 261.

Figure lOb illustrates a perspective view of the magnetic portion 200 when it is turned OFF. Lever 223 in this position is substantially perpendicular to lever 223 in the left side position as shown in Figure 10a, i.e. magnet parts 221 and 223 are turned 90 degrees relative to magnetic conductive parts 211 and 213. Magnet parts 221 and 223 each face part of magnetic conductive parts 211 and 213. As a result, most magnetic lines from the north pole of magnet part 221 pass magnetic conductive parts 211 and 213 and reach the south pole of magnet part 223, therefore the magnetic portion 200 has no external magnetic force to attach the multimeter to metal support 261. In one embodiment, ring 235 can be removed and only lever 233 is left.

The magnetic force between magnet parts 221 and 223 and magnetic conductive parts 211 and 213 may be strong. Without magnetic conductive cover 241, the friction generated in relative movement between magnet parts 221 and 223 and magnetic conductive parts 211 and 213 would also be strong. With the magnetic conductive cover 241, magnet parts 221 and 223 are drawn by magnetic force to magnetic conductive cover 241 and magnetic conductive parts 211 and 213, respectively. Therefore, the friction between magnet parts 221 and 223 and magnetic conductive parts 211 and 213 is reduced. In addition, magnetic conductive cover 241 can reduce magnetic leakage of magnetic portion 200.

In another embodiment, the structure of magnetic portion 200 may be kept unchanged, but the allocation of the north pole and south pole of magnet parts 221 and 223 is changed. In one embodiment, the north pole and the south pole of magnet parts 221 and 223 are allocated at two opposite ends along the horizontal direction of magnet parts 221 and 223, and the north pole of magnet parts 221 and 223 is at the left end and the south pole of magnet parts 221 and 223 is at the right end. When lever 233 is moved to the leftmost position, magnet part 221 overlaps magnetic conductive part 213 and magnet part 223 overlaps magnetic conductive part 211, thus most magnetic lines from the north pole of magnet part 221 pass magnetic conductive part 213 and reach the south pole of magnet part 221 and most magnetic lines from the north pole of magnet part 223 pass magnetic conductive part 211 and reach the south pole of magnet part 223. As a result, magnetic portion 200 has little or no external magnetic force, and cannot attach the multimeter to a metal support. When lever 233 is moved to the rightmost position, each of magnet parts 221 and 223 faces part of magnetic conductive parts 211 and 213, thus most magnetic lines from the north pole of magnet parts 221 and 223 pass one of magnetic conductive parts 211 and 213, a metal support, and the other of magnetic conductive parts 211 and 213, and reach the south pole of magnet parts 221 and 223. Consequently, the external magnetic force of magnetic portion 200 is strong enough to attach the multimeter to the metal support. In one embodiment, one of magnet parts 221 and 223 can be removed.

In one embodiment, magnetic conductive parts 211 and 213 and magnet parts 221 and 223 are flat arch shaped. They may be made in other shapes including, for example, flat rectangular shaped, flat oval shaped, flat triangular shaped, and flat polygonal shaped.

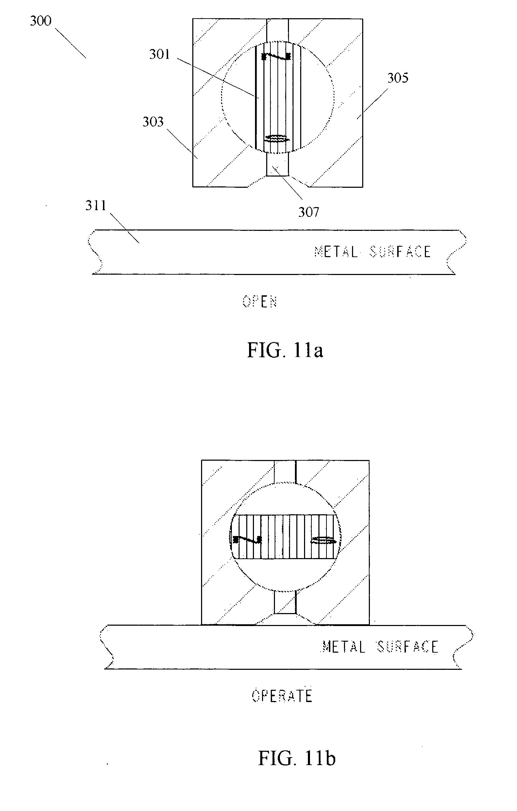

Figure 11a illustrates another embodiment of a magnetic portion 300. Magnetic portion 300 comprises magnet part 301, magnetic conductive parts 303 and 305, and spacing strip 307. Magnetic conductive parts 303 and 305 are separated by spacing strip 307. Magnet part 301 is placed in a chamber formed by magnetic conductive parts 303 and 305, and is rotatable relative to magnetic conductive parts 303 and 305. When magnet part 301 is in a position illustrated in Figure 11a, most magnetic lines from the north pole of magnet part 301 pass magnetic conductive parts 303 and 305, and reach the south pole of magnet part 301. As a result, magnetic portion 300 cannot attach a multimeter (not shown) to metal support 311.

When magnet part 301 is in a position illustrated in Figure 11b, magnetic lines from the north pole of magnet part 301 may pass through magnetic conductive part 303, metal support 311, and magnetic conductive part 305, and reach the south pole of magnet part 301. As a result, magnetic portion 300 can attach the multimeter to metal support 311. In one embodiment, the magnetic portion may contain electromagnets as magnet parts.

It can be appreciated that the objectives of the present invention have been fully and effectively accomplished. The foregoing specific embodiments have been provided to illustrate the structural and functional principles of the present invention as defined in the appended claims.

## Claims

1. A multimeter, comprising:
a first set of controls (11, 21) configured for selecting a first measurement function of the multimeter;
a second set of controls (12, 22) configured for selecting a second measurement function of the multimeter; and
a display screen (15, 25) disposed on a first face of the multimeter;
wherein the first set of controls (11, 21) and the second set of controls (12, 22) are spatially separated by the display screen (15, 25)
**characterised in that**
the display screen (15, 25) changes its display orientation in response to selection of one of the first and second measurement functions so that the display (15, 25) can be conveniently read by the user.

2. The multimeter of claim 1, further comprising a first input device (13, 23) and a second input device (14, 24) where the first and second input devices are configured to obtain measurement data from an electrical circuit and are used for perform the respective measurement function selected by the first set of controls (11, 21) or the second set of controls (12, 22).

3. The multimeter of claim 2 wherein the first set of controls (11, 21) and the first input device (13, 23) are located at a first end of the multimeter, and the second set of controls (12, 22) and the second input device (14, 24) are located at a second end that is opposite to the first end of the multimeter.

4. The multimeter of claim 2 or 3, wherein at least one of the first and second input devices (13, 23) comprises a pair of test leads (41,44) with extension wires (42,45), and/or further comprising an input jack (43,48') to directly connect a test lead without extension wire.

5. The multimeter of claim 2, 3 or 4 wherein at least one of the first and second input devices (14, 24) comprises a non-contact type measurement sensor (14,24).

6. The multimeter of any preceding claim, wherein the first and second control panels are disposed on opposite sides of the display,

7. The multimeter of claims 4 and 6, wherein the first input device is controlled with the second control panel and the second input device is controlled with the first control panel, wherein the first control panel and the first input device are located on a first side of the display and the second control panel and second input device are located on a second side of the display.

8. The multimeter of any preceding claim, further comprising:
a magnetic portion (61, 200) to magnetically attach the multimeter to a metal surface; and
a switch (231) to turn ON and OFF the magnetic portion (61, 200), wherein when the magnetic portion (61, 200) is turned ON the magnetic portion (61, 200) provides a magnetic force such that the multimeter can be magnetically attached to a metal surface, and when the magnetic portion (61, 200) is turned OFF the magnetic portion (61, 200) does not provide a sufficient magnetic force such that the multimeter can be magnetically attached to a metal surface.

9. The multimeter of claim 8, wherein the magnetic portion includes at least one magnet part (221,223) and at least one magnetic conductive part (211,213), wherein the at least one magnet part and the at least one magnetic conductive part move relative to each other to switch the magnetic portion ON and OFF.

10. The multimeter of claim 9, wherein the magnet part (221,223) and the magnetic conductive part turn (211,213) relative to each other to switch the magnetic portion ON and OFF.

11. The multimeter of claim 9 or 10, further comprising a magnetic conductive cover (241), wherein the magnet part (221,223) is sandwiched between the magnetic conductive cover and the magnetic conductive part (211,213).

12. The multimeter of any preceding claim, wherein the measurement function is selected from the group comprising current, voltage, resistance, capacitance, frequency, power, temperature and humidity.

## Patentansprüche

1. Multimeter, das folgendes umfasst:
eine erste Gruppe von Bedienelementen (11, 21), die für die Auswahl einer ersten Messfunktion des Multimeters konfiguriert sind;
eine zweite Gruppe von Bedienelementen (12, 22), die für die Auswahl einer zweiten Messfunktion des Multimeters konfiguriert sind; und
einen Bildschirm (15, 25), der auf einer ersten Seite des Multimeters angeordnet ist;
wobei die erste Gruppe von Bedienelementen (11, 21) und die zweite Gruppe von Bedienelementen (12, 22) durch den Bildschirm (15, 25) räumlich voneinander getrennt sind;
**dadurch gekennzeichnet, dass**:
der Bildschirm (15, 25) seine Anzeigenausrichtung als Reaktion auf die Auswahl der ersten oder der zweiten Messfunktion verändert, so dass der Bildschirm (15, 25) bequem durch den Benutzer abgelesen werden kann.

2. Multimeter nach Anspruch 1, wobei dieses ferner eine erste Eingabevorrichtung (13, 23) und eine zweite Eingabevorrichtung (14, 24) umfasst, wobei die erste und die zweite Eingabevorrichtung so konfiguriert sind, dass sie Messdaten von einem elektrischen Schaltkreis erhalten, und wobei sie eingesetzt werden, um die entsprechende Messfunktion auszuführen, die von der ersten Gruppe von Bedienelementen (11, 21) oder der zweiten Gruppe von Bedienelementen (12, 22) ausgewählt worden ist.

3. Multimeter nach Anspruch 2, wobei die erste Gruppe von Bedienelementen (11, 21) und die erste Eingabevorrichtung (13, 23) an einem ersten Ende des Multimeters angeordnet sind, und wobei die zweite Gruppe von Bedienelementen (12, 22) und die zweite Eingabevorrichtung (14, 24) an einem zweiten Ende angeordnet sind, das zu dem ersten Ende des Multimeters entgegengesetzt angeordnet ist.

4. Multimeter nach Anspruch 2 oder 3, wobei mindestens eine der ersten und zweiten Eingabevorrichtungen (13, 23) ein Paar von Prüfleitungen (41, 44) mit Verlängerungsdrähten (42, 45) und/oder ferner eine Eingangsbuchse (43, 48') zur direkten Verbindung einer Prüfleitung ohne Anschlussdraht umfasst.

5. Multimeter nach Anspruch 2, 3 oder 4, wobei mindestens eine der ersten und zweiten Eingabevorrichtungen (14, 24) einen berührungslosen Messsensor (14, 24) umfasst.

6. Multimeter nach einem der vorstehenden Ansprüche, wobei die ersten und zweiten Bedienfelder auf gegenüberliegenden Seiten des Bildschirms angeordnet sind.

7. Multimeter gemäß den Ansprüchen 4 und 6, wobei die erste Eingabevorrichtung über das zweite Bedienfeld bedient wird, und wobei die zweite Eingabevorrichtung über das erste Bedienfeld bedient wird, wobei sich das erste Bedienfeld und die erste Eingabevorrichtung auf einer ersten Seite des Bildschirms befinden, und wobei sich das zweite Bedienfeld und die zweite Eingabevorrichtung auf einer zweiten Seite des Bildschirms befinden.

8. Multimeter nach einem der vorstehenden Ansprüche, wobei dieses ferner folgendes umfasst:
einen magnetischen Abschnitt (61, 200), um das Multimeter magnetisch an einer Metalloberfläche anzubringen; und
einen Schalter (231), der dazu dient, den magnetischen Abschnitt (61, 200) ein- und auszuschalten, wobei, wenn der magnetische Abschnitt (61, 200) eingeschaltet ist, der magnetische Abschnitt (61, 200) eine Magnetkraft bereitstellt, so dass das Multimeter magnetisch an einer Metalloberfläche angebracht werden kann, und wenn der magnetische Abschnitt (61, 200) ausgeschaltet ist, stellt der magnetische Abschnitt (61, 200) keine ausreichende Magnetkraft für eine magnetische Anbringung des Multimeters an einer Metalloberfläche bereit.

9. Multimeter nach Anspruch 8, wobei der magnetische Abschnitt mindestens einen Magnetteil (221, 223) und mindestens einen magnetisch leitfähigen Teil (211, 213) aufweist, wobei sich der mindestens eine Magnetteil und der mindestens eine magnetisch leitfähige Teil im Verhältnis zueinander bewegen, um den magnetischen Abschnitt ein- und auszuschalten.

10. Multimeter nach Anspruch 9, wobei sich der Magnetteil (221, 223) und der magnetisch leitfähige Teil (211, 213) im Verhältnis zueinander drehen, um den magnetischen Abschnitt ein- und auszuschalten.

11. Multimeter nach Anspruch 9 oder 10, wobei dieses ferner eine magnetisch leitfähige Abdeckung (241) umfasst, wobei sich der magnetische Teil (221, 223) in SandwichAnordnung zwischen der magnetisch leitfähigen Abdeckung und dem magnetisch leitfähigen Teil (211, 213) befindet.

12. Multimeter nach einem der vorstehenden Ansprüche, wobei die Messfunktion aus der Gruppe ausgewählt wird, die Strom, Spannung, Widerstand, Kapazität, Frequenz, Leistung, Temperatur und Luftfeuchtigkeit umfasst.

## Revendications

1. Multimètre, comprenant :
un premier ensemble de commandes (11, 21) conçu pour sélectionner une première fonction de mesure du multimètre ;
un second ensemble de commandes (12, 22) conçu pour sélectionner une seconde fonction de mesure du multimètre ; et
un écran d'affichage (15, 25) situé sur une première face du multimètre ;
dans lequel le premier ensemble de commandes (11, 21) et le second ensemble de commandes (12, 22) sont spatialement séparés par l'écran d'affichage (15, 25)
**caractérisé en ce que**
l'écran d'affichage (15, 25) change son orientation d'affichage en réponse à la sélection de l'une des première et seconde fonctions de mesure de sorte que l'écran (15, 25) peut être aisément lu par l'utilisateur.

2. Multimètre selon la revendication 1, comprenant en outre un premier dispositif d'entrée (13, 23) et un second dispositif d'entrée (14, 24) dans lequel les premier et second dispositifs d'entrée sont conçus pour obtenir des données de mesure à partir d'un circuit électrique et sont utilisés pour effectuer la fonction de mesure respective sélectionnée par le premier ensemble de commandes (11, 21) ou le second ensemble de commandes (12, 22).

3. Multimètre selon la revendication 2, dans lequel le premier ensemble de commandes (11, 21) et le premier dispositif d'entrée (13, 23) sont situés à une première extrémité du multimètre, et le second ensemble de commandes (12, 22) et le second dispositif d'entrée (14, 24) sont situés à une seconde extrémité qui est opposée à la première extrémité du multimètre.

4. Multimètre selon la revendication 2 ou 3, dans lequel le premier et/ou le second dispositifs d'entrée (13, 23) comprennent une paire de câbles d'essai (41, 44) pourvus de fils d'extension (42, 45), et/ou comprennent en outre une prise d'entrée (43, 48') pour connecter directement un câble d'essai sans fil d'extension.

5. Multimètre selon la revendication 2, 3 ou 4, dans lequel le premier et/ou le second dispositifs d'entrée (14, 24) comprennent un capteur de mesure de type sans contact (14, 24).

6. Multimètre selon l'une quelconque des revendications précédentes, dans lequel les premier et second panneaux de commande sont situés sur des côtés opposés de l'écran.

7. Multimètre selon les revendications 4 et 6, dans lequel le premier dispositif d'entrée est commandé au moyen du second panneau de commande et le second dispositif d'entrée est commandé au moyen du premier panneau de commande, dans lequel le premier panneau de commande et le premier dispositif d'entrée sont situés sur un premier côté de l'écran et le second panneau de commande et le second dispositif d'entrée sont situés sur un second côté de l'écran.

8. Multimètre selon l'une quelconque des revendications précédentes, comprenant en outre :
une partie magnétique (61, 200) pour fixer magnétiquement le multimètre sur une surface métallique ; et
un commutateur (231) pour mettre sous tension et hors tension la partie magnétique (61, 200), dans lequel lorsque la partie magnétique (61, 200) est mise sous tension, la partie magnétique (61, 200) fournit une force magnétique de sorte que le multimètre peut être magnétiquement fixé sur une surface métallique, et lorsque la partie magnétique (61, 200) est mise hors tension, la partie magnétique (61, 200) ne fournit pas une force magnétique suffisante pour que le multimètre puisse être magnétiquement fixé sur une surface métallique.

9. Multimètre selon la revendication 8, dans lequel la partie magnétique comprend au moins une partie aimant (221, 223) et au moins une partie conductrice magnétique (211, 213), dans lequel l'au moins une partie aimant et l'au moins une partie conductrice magnétique se déplacent l'une par rapport à l'autre pour mettre la partie magnétique sous tension ou hors tension.

10. Multimètre selon la revendication 9, dans lequel la partie aimant (221, 223) et la partie conductrice magnétique (211, 213) tournent l'une par rapport à l'autre pour mettre sous tension et hors tension la partie magnétique.

11. Multimètre selon la revendication 9 ou 10, comprenant en outre un couvercle conducteur magnétique (241), dans lequel la partie aimant (221, 223) est prise en sandwich entre le couvercle conducteur magnétique et la partie conductrice magnétique (211, 213).

12. Multimètre selon l'une quelconque des revendications précédentes, dans lequel la fonction de mesure est choisie dans le groupe constitué par le courant, la tension, la résistance, la capacité, la fréquence, la puissance, la température et l'humidité.
